Europäisches Patentamt

European Patent Office

Office européen des brevets

(11) Publication number: **0 344 715**
**A2**

# EUROPEAN PATENT APPLICATION

(21) Application number: 89109740.4

(22) Date of filing: 30.05.89

(51) Int. Cl.⁴: **H02H 7/20 , H02H 5/04**

(30) Priority: 31.05.88 JP 133659/88

(43) Date of publication of application:
06.12.89 Bulletin 89/49

(84) Designated Contracting States:
**DE FR GB**

(71) Applicant: **FUJITSU LIMITED**
**1015, Kamikodanaka Nakahara-ku**
**Kawasaki-shi Kanagawa 211(JP)**

(72) Inventor: **Kokado, Masayuki**
**1-2-2-201, Oyamadasakuradai**
**Machida-shi Tokyo, 194-02(JP)**

(74) Representative: **Schmidt-Evers, Jürgen,**
**Dipl.-Ing. et al**
**Patentanwälte Dipl.-Ing. H. Mitscherlich**
**Dipl.-Ing. K. Gunschmann Dipl.-Ing.**
**Dr.rer.nat. W. Körber Dipl.-Ing. J.**
**Schmidt-Evers Dipl.-Ing. W. Melzer**
**Steinsdorfstrasse 10**
**D-8000 München 22(DE)**

(54) Semiconductor integrated circuit device having temperature detecting means.

(57) A semiconductor integrated circuit device is formed on a single substrate and comprises an emitter coupled logic circuit (10) including a pair of first transistors (Q11, Q12) having emitters thereof connected in common and collectors thereof coupled to a first power source ($V_{cc}$) and a second transistor (Q15) having a collector thereof connected to the emitters of the first transistors and an emitter thereof coupled to a second power source ($V_{ee}$), where the second transistor supplies a current to the first transistors, a bias circuit (40) for supplying to a base of the second transistor a bias voltage ($V_{cs}$) which has a first voltage in a normal operating state, a temperature sensor (20) provided in a vicinity of the emitter coupled logic circuit for detecting a temperature, and an abnormal temperature detection circuit (30) coupled between the temperature sensor and the bias circuit for outputting an abnormal temperature signal when the temperature detected by the temperature sensor exceeds a predetermined value (T0). The bias circuit changes the bias voltage from the first voltage to a second voltage responsive to the abnormal temperature signal from the abnormal temperature detection circuit in a shut-down state so that the second transistor of the emitter coupled logic circuit is turned OFF.

*FIG. 1*

## SEMICONDUCTOR INTEGRATED CIRCUIT DEVICE HAVING TEMPERATURE DETECTING MEANS

### BACKGROUND OF THE INVENTION

The present invention generally relates to semiconductor integrated circuit devices, and more particularly to a semiconductor integrated circuit device having a function of protecting a large scale integrated circuit from a thermal destruction caused by a rise in temperature.

In a bipolar emitter coupled logic (ECL) circuit type large scale integrated circuit (LSI) in particular, the power consumption is increasing with the improvement in the operation speed and integration density. Hence, a cooling system for cooling the LSI is changing from an air cooled system to a forced air cooled system and a liquid cooled system. When an abnormality occurs in the cooling system, the temperature of the LSI which is operating rises quickly and in some cases instantaneously reaches a destruction temperature. Accordingly, it is necessary to detect the rise in the LSI temperature before it reaches the destruction temperature and stop the heat generation of the LSI so as to protect the LSI from thermal destruction by the self-generated heat.

Conventionally, a protection circuit for protecting the LSI from thermal destruction is provided not within the LSI but externally to the LSI in a device on which the LSI is mounted. For example, the protection circuit monitors the air temperature within the device or the operation of a motor which drives a cooling fan. When the protection circuit detects an abnormality, the protection circuit cuts off the supply of power to the LSI so as to stop the heat generation of the LSI and accordingly prevent the thermal destruction.

However, according to such a system of monitoring the external temperature of the LSI, there is a relatively large difference between the actual LSI temperature and the detected temperature. In addition, a temperature rise within the LSI caused by an abnormality in the cooling system is transmitted outside the LSI but the external temperature of the LSI only rises after a considerable time delay. For this reason, there is a problem in that the method of detecting the external temperature of the LSI cannot positively prevent the thermal destruction because of the above described delay in detecting the temperature rise and protecting the LSI.

On the other hand, a Japanese Laid-Open Patent Application No.56-120153 proposes an integrated circuit having a temperature protector provided inside the integrated circuit. However, there is a problem in that a power source voltage required to drive the temperature protector is greater than a power source voltage required by the integrated circuit. As a result, the power consumption of this proposed integrated circuit is large.

### SUMMARY OF THE INVENTION

Accordingly, it is a general object of the present invention to provide a novel and useful semiconductor integrated circuit device in which the problems described above are eliminated.

Another and more specific object of the present invention is to provide a semiconductor integrated circuit device formed on a single substrate and comprising a first power source, a second power source for supplying a voltage different from a voltage supplied by the first power source, an emitter coupled logic circuit including a pair of first transistors having emitters thereof connected in common and collectors thereof operatively coupled to the first power source and a second transistor having a collector thereof connected to the emitters of the first transistors and an emitter thereof operatively coupled to the second power source, where the second transistor supplies a current to the first transistors, a bias circuit for supplying a bias voltage to a base of the second transistor, where the bias voltage has a first voltage in a normal operating state, a temperature sensor provided in a vicinity of the emitter coupled logic circuit for detecting a temperature, and an abnormal temperature detection circuit coupled between the temperature sensor and the bias circuit for outputting an abnormal temperature signal when the temperature detected by the temperature sensor exceeds a predetermined value. The bias circuit includes means for changing the bias voltage from the first voltage to a second voltage which is different from the first voltage responsive to the abnormal temperature signal from the abnormal temperature detection circuit in a shut-down state so that the second transistor of the emitter coupled logic circuit is turned OFF. According to the semiconductor integrated circuit device of the present invention, it is possible to quickly detect a rise in the temperature of the emitter coupled logic circuit (that is, the LSI) and positively prevent thermal destruction thereof.

Other objects and further features of the present invention will be apparent from the following detailed description when read in conjunction with the accompanying drawings.

### BRIEF DESCRIPTION OF THE DRAWINGS

FIG.1 is a circuit diagram showing an embodiment of a semiconductor integrated circuit device according to the present invention;

FIGS.2(A) through 2(D) show signal waveforms for explaining an operation of the embodiment shown in FIG.1; and =

FIG.3 is a circuit diagram showing a circuit for generating a reference voltage supplied to an LSI in FIG.1.

## DESCRIPTION OF THE PREFERRED EMBODIMENTS

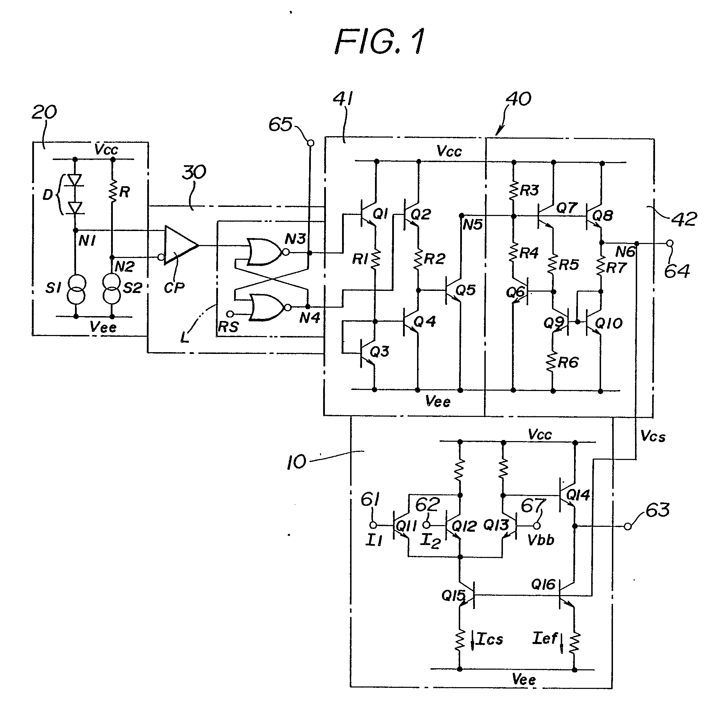

FIG.1 shows an embodiment of a semiconductor integrated circuit device according to the present invention. The semiconductor integrated circuit device has a large scale integrated circuit (LSI) 10 which is to be protected from thermal destruction, a temperature sensor 20 for protecting the LSI 10 from abnormal temperatures, an abnormal temperature detection circuit 30, and a bias circuit 40 having a shut-down function. The LSI 10, the temperature sensor 20, the abnormal temperature detection circuit 30, and the bias circuit 40 are provided on a common single substrate (not shown) of the semiconductor integrated circuit device.

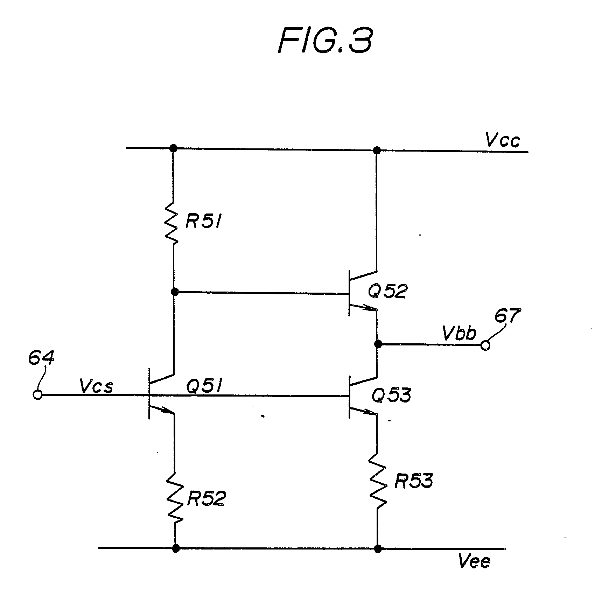

The LSI 10 is made up of an emitter coupled logic (ECL) circuit including a transistor Q15 for supplying a constant current $I_{cs}$ to a current switch circuit and a transistor Q16 for supplying a constant current $I_{ef}$ to an emitter follower circuit. The transistor Q15 of the current switch circuit is coupled to a collector voltage source $V_{cc}$ through a transistor Q11 which receives a first input I1 from a terminal 61, a transistor Q12 which receives a second input I2 from a terminal 62, and a transistor Q13 which receives a reference voltage $V_{bb}$ from a circuit which will be described later in conjunction with FIG.3. The current switch circuit is connected to an emitter voltage source $V_{ee}$. The transistor Q16 of the emitter follower circuit is coupled to the collector voltage source $V_{cc}$ through a transistor Q14. A base of the transistor Q14 is connected to a collector of the transistor Q13. An OR output signal from an emitter of the transistor Q14 is output from an output terminal 63. A bias voltage $V_{cs}$ which will be described later is applied to bases of the transistors Q15 and Q16.

The temperature sensor 20 detects the temperature of the LSI 10 by use of the fact that a diode D and a resistor R have mutually different temperature coefficients and supplies voltages which are dependent on the detected temperature to the abnormal temperature detection circuit 30. The temperature sensor 20 is provided in a vicinity of the LSI 10, and is provided at a central portion of the substrate in this embodiment. The diode D and the resistor R are connected in series to respective constant current sources S1 and S2. The output voltages of the temperature sensor 20 are obtained from a node N1 which connects the diode D and the constant current source S1 and from a node N2 which connects the resistor R and the constant current source S2. The nodes N1 and N2 correspond to output terminals of the temperature sensor 20.

The abnormal temperature detection circuit 30 includes a comparator CP and a latch circuit L. The output voltages of the temperature sensor 20 are supplied to the comparator CP.

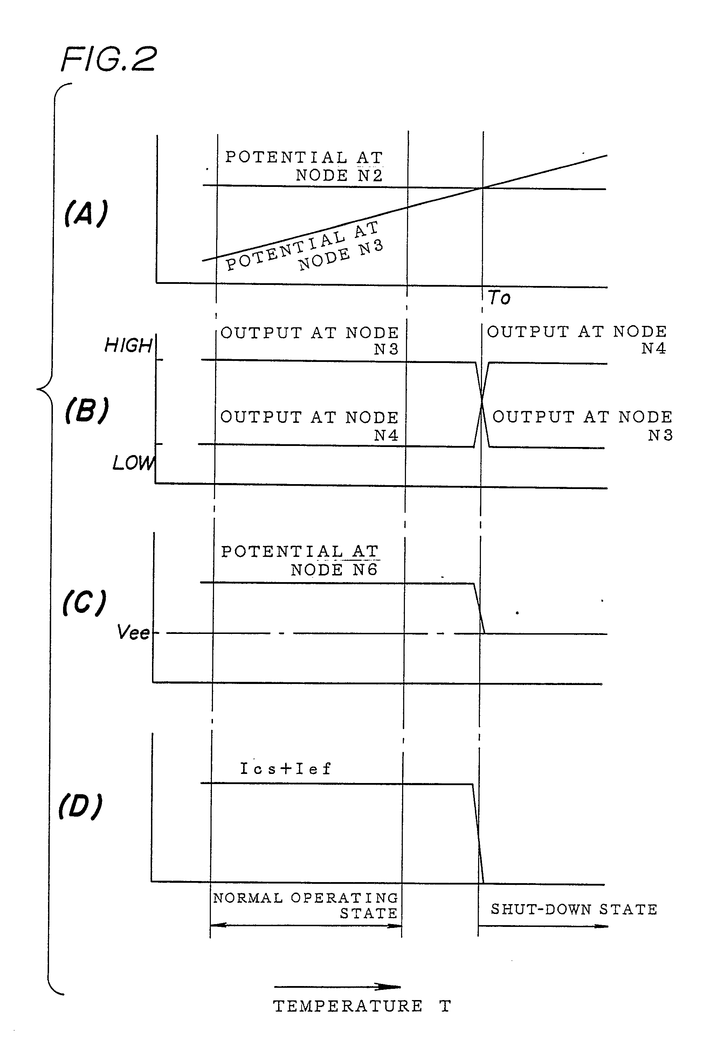

The temperature sensor 20 is designed so that the potential at the node N1 is lower than the potential at the node N2 at the normal operating temperatures. As a temperature T of the LSI 10 rises, the terminal voltage of the diode D decreases while the resistance of the resistor R virtually remains unchanged. For this reason, when the rise in the temperature T of the LSI 10 continues, the polarity of the voltage across the nodes N1 and N2 becomes inverted about a predetermined temperature T0 where the potentials at the nodes N1 and N2 become equal, as shown in FIG.2(A). That is, the polarities of the input voltages of the comparator CP are inverted about the predetermined temperature T0, and a logic output of the comparator CP is inverted accordingly. The latch circuit L stores an output inversion of the comparator CP and outputs the output inversion as an abnormal temperature signal. The output inversion of the latch circuit L continues until a reset signal is applied to a reset terminal $R_s$. During a normal operation of the latch circuit L before the output inversion, a node N3 is at a high level and a node N4 is at a low level, and the output inversion occurs due to the temperature rise of the LSI 10 as shown in FIG.2(B). The nodes N3 and N4 correspond to output terminals of the abnormal temperature detection circuit 30.

The predetermined temperature T0 is set to a value which is higher than a maximum temperature (for example, in the order of 125 °C) at which the operation of the LSI 10 is guaranteed. For example, it is appropriate to set the predetermined temperature T0 within a temperature range of 150 °C to 200 °C in which the functional operation of the LSI 10 is correct. The predetermined temperature T0 is set in this manner by appropriately selecting the values and characteristics of the diode D, the resistor R and the constant current sources S1 and S2.

The bias circuit 40 having the shut-down function is made up of a shut-down part 41 which includes transistors Q1 through Q5, and a bias circuit part 42 which includes transistors Q6 through Q10. An output signal of the shut-down part 41 is obtained from a node N5, and an output signal of the bias circuit part 42 is obtained from a node N6. The transistors Q1 and Q2 form an input portion of the shut-down part 41, and the transistors Q3 and Q4 form a current mirror circuit. A collector of the transistor Q3 is coupled to an emitter of the transistor Q1 through a resistor R1, while a collector of the transistor Q4 is coupled to an emitter of the transistor Q2 through a resistor R2. The resistors R1 and R2 have identical resistances. The collector of the transistor Q4 is also connected to a base of the transistor Q5, and the collector of the transistor Q5 is also connected to the node N5 which corresponds to an output terminal of the shut-down part 42.

As described above, the node N3 is at the high level and the node N4 is at the low level during the normal operation. In addition, identical currents constantly flow through the transistors Q3 and Q4. Furthermore, the resistances of the resistors R1 and R2 are the same. Accordingly, the voltage difference between the nodes N3 and N4 appear between the collectors of the transistors Q3 and Q4, and the collector voltage of the transistor Q4 becomes a predetermined value $\Delta V$ (voltage difference between the nodes N3 and N4) lower than the collector voltage of the transistor Q3. As a result, the transistor Q5 is cut off.

The bias circuit part 42 has the transistors Q6 through Q10 and resistors R3 through R7. When the transistor Q5 of the shut-down part 41 is cut off, the bias circuit part 42 generates a bias voltage $V_{cs}$ at the node N6 by a normal operation and supplies this bias voltage $V_{sc}$ to the LSI 10. As a result, a control is carried out so that the current $I_{cs}$ is supplied to the transistor Q15 which constitutes the current switch circuit within the LSI 10 and the current $I_{ef}$ is supplied to the transistor Q16 which constitutes the emitter follower circuit within the LSI 10.

Next, a description will be given of the case where the temperature T of the LSI 10 exceeds the predetermined temperature T0. In this case, the shut-down function of the shut-down part 41 is activated by the abnormal temperature signal from the abnormal temperature detection circuit 30, and no current flows to the LSI 10. In other words, the potential at the node N1 becomes higher than that at the node N2 in this case, and consequently, the levels at the nodes N3 and N4 respectively become high and low thereby turning the transistor Q5 ON. A collector current of this transistor Q5 flows through the resistor R3 and the voltage at the node N5 drops to approximately a saturation voltage (for example, in the order of 0.1 V) between the collector and emitter of the transistor Q5. As a result, the transistor Q8 is cut off, and the voltage $V_{cs}$ at the node N6 drops to the minimum voltage

$V_{ee}$ as shown in FIG.2(C). Thus, the transistors Q15 and Q16 which are used as constant current sources in the LSI 10 are cut off, and the currents $I_{cs}$ and $I_{ef}$ no longer flow as shown in FIG.2(D). Therefore, the heat generation of the LSI 10 stops and the temperature T of the LSI 10 (that is, the chip temperature) decreases.

The reset terminal $R_s$ of the abnormal temperature detection circuit 30 is normally at a low level. Hence, the latch circuit L stores the output inversion of the comparator CP and the output inversion of the latch circuit L continues until the reset signal is applied to the reset terminal $R_s$. The latch circuit L is provided to prevent an unstable operation of the shut-down part 41 which may occur when the temperature T detected by the temperature sensor 20 fluctuates within a certain temperature range. However, it is possible to return the bias circuit 40 to the normal operating state from the shut-down state by applying a high-level reset signal to the reset terminal $R_s$.

A monitoring terminal 65 may be connected to any of the nodes N3 through N6 for the purpose of monitoring the state of the bias circuit 40, that is, whether the bias circuit 40 is in the normal operating state or the shut-down state. In this embodiment, the monitoring terminal 65 is shown as being connected to the node N3 for the sake of convenience. In this case, it is possible to detect that the bias circuit 40 is in the normal operating state when the signal level at the monitoring terminal 65 is high and is in the shut-down state when the signal level at the monitoring terminal 65 is low.

FIG.3 shows the circuit which generates the reference voltage $V_{bb}$ which is supplied to a base of the transistor Q13 of the LSI 10. A reference voltage generating circuit 50 is coupled to a terminal 64 which connects to the node N6. The reference voltage generating circuit 50 includes a resistor R51, a transistor Q51, and a resistor R52 which are connected in series between the voltage sources $V_{cc}$ and $V_{ee}$, and transistors Q52 and Q53 and a resistor R53 which are connected in series between the voltage sources $V_{cc}$ and $V_{ee}$. The voltage $V_{cs}$ from the terminal 64 is supplied to bases of the transistors Q51 and Q53. A base of the transistor Q52 is connected to a collector of the transistor Q51. A terminal 67 is connected to a node which connects a collector of the transistor Q53 and an emitter of the transistor Q52. and the reference voltage $V_{bb}$ is output from this terminal 67.

It was described heretofore that the LSI 10 is made up of one current switch circuit and one emitter follower circuit for the sake of convenience. Generally, the LSI 10 has a plurality of current switch circuits and emitter follower circuits, and the heat generation mainly occurs at these parts of the LSI 10. A current slightly flows through the temperature sensor 20, the abnormal temperature detection circuit 30, and the bias circuit 40 even in the shut-down state, but the number of elements constituting these circuits is small and the heat generated thereby is virtually negligible.

According to this embodiment, the shut-down function is activated when the temperature T of the LSI 10 exceeds the predetermined temperature T0, and the heat generation of the LSI 10 is greatly reduced. Therefore, it is possible to positively protect the LSI 10 from thermal destruction. It is expected that the integration density and the power consumption of the bipolar LSI will further increase in the future, and the present invention is applicable to such a bipolar LSI for the purpose of positively preventing the thermal destruction.

In the described embodiment, the LSI 10 is shown as a simple ECL circuit. However, the present invention is similarly applicable to other types of LSIs having a bias circuit for the constant current source.

The temperature sensor 20 of the embodiment is made up of the diode D and the resistor R. However, it is of course possible to constitute the temperature sensor 20 from other elements as long as the elements can be formed on the substrate of the semiconductor integrated circuit device and can detect the temperature rise.

Further, the present invention is not limited to these embodiments, but various variations and modifications may be made without departing from the scope of the present invention.

**Claims**

A semiconductor integrated circuit device formed on a single substrate and comprising a first power source ($V_{cc}$), a second power source ($V_{ee}$) for supplying a voltage different from a voltage supplied by said first power source, an emitter coupled logic circuit (10) including a pair of first transistors (Q12, Q13) having emitters thereof connected in common and collectors thereof operatively coupled to said first power source and a second transistor (Q15) having a collector thereof connected to the emitters of said first transistors and an emitter thereof operatively coupled to said second power source, said second transistor supplying a current to said first transistors, and a bias circuit (40) for supplying a bias voltage ($V_{cs}$) to a base of said second transistor, said bias circuit supplying the bias voltage which has a first voltage in a normal operating state, characterized in that there are provided: a temperature sensor (20) provided in a vicinity of said emitter coupled logic circuit (10) for detecting a temperature; and an abnormal temperature detection circuit (30) coupled between said temperature sensor and said bias circuit (40) for outputting an abnormal temperature signal when the temperature detected by said temperature sensor exceeds a predetermined value (T0), said bias circuit including means for changing the bias voltage ($V_{cs}$) from the first voltage to a second voltage which is different from the first voltage responsive to the abnormal temperature signal from said abnormal temperature detection circuit in a shut-down state so that said second transistor (Q15) of said emitter coupled logic circuit is turned OFF.

2. The semiconductor integrated circuit device as claimed in claim 1, characterized in that said temperature sensor (20) includes a diode part (D) and a first current source (S1) connected in series between said first and second power sources ($V_{cc}$, $V_{ee}$), and a resistor (R) and a second current source (S2) connected in series between said first and second power sources, said diode part being made up of a plurality of diodes connected in series.

3. The semiconductor integrated circuit device as claimed in claim 2, characterized in that said abnormal temperature detection circuit (30) includes a comparator (CP) for comparing a potential at a first node (N1) between said diode part (D) and said first current source (S1) of said temperature sensor (20) and a potential at a second node (N2) between said resistor (R) and said second current source (S2) of said temperature sensor, and a latch circuit (L) for latching an output signal of said comparator as the abnormal temperature signal when the temperature detected by said temperature sensor exceeds the predetermined value (T0) and the output signal of said comparator undergoes a polarity inversion.

4. The semiconductor integrated circuit device as claimed in claim 3, characterized in that the potential at said first node (N1) has a first characteristic which increases approximately linearly to a rise in the temperature and the potential at said second node (N2) has a second characteristic which is approximately constant regardless of the temperature, said first and second characteristics intersecting at said predetermined value (T0).

5. The semiconductor integrated circuit device as claimed in claim 3 or 4, characterized in that said latch circuit (L) has a reset terminal ($R_s$) for receiving a reset signal, said latch circuit holding the polarity inversion of the output signal of said comparator (CP) until the reset signal is received at said reset terminal.

6. The semiconductor integrated circuit device as claimed in any of claims 1 to 5, characterized in that said bias circuit (40) has a shut-down part (41) and a bias circuit part (42) for outputting the bias voltage ($V_{cs}$), said shut-down part disabling said bias circuit part responsive to the abnormal temperature signal from said abnormal temperature detection circuit (30).

7. The semiconductor integrated circuit device as claimed in claim 6, characterized in that said bias circuit part (42) includes a third transistor (Q8) coupled to said first power source ($V_{cc}$) for outputting the bias voltage ($V_{cs}$), said shut-down part (41) including a fourth transistor (Q5) coupled to said second power source ($V_{ee}$) for decreasing a base voltage of said third transistor responsive to the abnormal temperature signal.

8. The semiconductor integrated circuit device as claimed in any of claims 1 to 7, characterized in that there is further provided terminal means (65) for indicating by a signal level thereof whether said bias circuit (40) is in the normal operating state or the shut-down state.

9. The semiconductor integrated circuit device as claimed in claim 8, characterized in that said terminal means (65) is connected to an output of said abnormal temperature detection circuit (30).

10. The semiconductor integrated circuit device as claimed in claim 8, characterized in that said terminal means (65) is connected to an output of said bias circuit (40).

# FIG.1

## FIG.2

**(A)**

POTENTIAL AT
NODE N2

POTENTIAL AT
NODE N3

$T_0$

**(B)**

HIGH

OUTPUT AT NODE
N3

OUTPUT AT NODE
N4

OUTPUT AT NODE
N4

OUTPUT AT NODE
N3

LOW

**(C)**

POTENTIAL AT
NODE N6

$V_{ee}$

**(D)**

$I_{cs}+I_{ef}$

NORMAL OPERATING
STATE

SHUT-DOWN STATE

TEMPERATURE T

# FIG.3